# EUROPEAN PATENT SPECIFICATION

(11) **EP 4 303 910 B1**
(45) Date of publication and mention of the grant of the patent: **22.10.2025**
(21) Application number: 22925225.9
(22) Date of filing: 16.06.2022
(51) Int. Cl.: H01L 21/3213, H01L 21/02, H01L 21/768

(54) **SEMICONDUCTOR STRUCTURE AND FORMING METHOD THEREFOR**
HALBLEITERSTRUKTUR UND HERSTELLUNGSVERFAHREN DAFÜR
STRUCTURE SEMI-CONDUCTRICE ET SON PROCÉDÉ DE FORMATION

(30) Priority: 24.05.2022 CN 202210571337
(43) Date of publication of application: 10.01.2024
(73) Proprietor: Changxin Memory Technologies, Inc., Hefei City, Anhui Province 230601 (CN)
(72) Inventor: WANG, Peimeng, Hefei, Anhui 230601 (CN); XI, Ning, Hefei, Anhui 230601 (CN); BAI, Shijie, Hefei, Anhui 230601 (CN)
(74) Representative: Lavoix
(86) International application number: PCT/CN2022/099225
(87) International publication number: WO 2023/226111

(56) References cited:
- CN-A- 102 610 493
- CN-A- 112 563 192
- KR-A- 20080 069 346
- US-A1- 2003 059 720
- US-A1- 2008 160 778
- US-A1- 2009 117 723
- US-A1- 2015 194 320
- US-A1- 2021 225 903

## Description

### CROSS-REFERENCE TO RELATED APPLICATION

### TECHNICAL FIELD

The present disclosure relates to the field of semiconductors, and relates, but is not limited, to a semiconductor method for forming a semiconductor structure.

### BACKGROUND

In a semiconductor device, a Landing Pad (LP) has to be formed between a capacitor structure and a transistor in a storage region, and a metal conductive layer has to be formed in a peripheral region. However, there tends to be some by-products remaining on the metal conductive layer during a process in forming the metal conductive layer. The by-products tend to cause a short circuit between adjacent metal conductive layers. Therefore, a new process for forming a metal conductive layer has to be provided to reduce short circuits between adjacent metal conductive layers. Related technologies are known from US 2009/117723 A1, US 2021/225903 A1, US 2015/194320 A1 and US 2003/059720 A1.

### SUMMARY

In view of this, embodiments of the present disclosure provide a semiconductor method for forming a semiconductor structure.

In a first aspect, embodiments of the present disclosure provide a method for forming a semiconductor structure. The method includes: providing a substrate, wherein an insulation layer, an initial metal conductive layer, an initial sacrifice layer, and a mask layer stacking in sequence are formed on the substrate, wherein the initial sacrifice layer includes a metal oxide layer; forming a metal conductive layer and a sacrifice layer atop the metal conductive layer by etching the initial sacrifice layer and the initial metal conductive layer using an oxygen source gas as an etching gas based on a patterned mask layer, as well as allowing a first by-product formed during the etching to mainly include a metal oxide; removing the patterned mask layer by performing an ashing process using the oxygen source gas as the etching gas, the oxygen source gas further allowing a second by-product formed in the ashing process to mainly include a metal oxide; removing the sacrifice layer as well as by-products including the first by-product formed during the etching and the second by-product formed during the ashing process and exposing the metal conductive layer by performing a corrosion process using an alkaline corrosion solution; and forming an isolation structure between adjacent metal conductive layers.

In some embodiments, the initial sacrifice layer is formed by: performing a planarization process on the initial metal conductive layer; and forming the initial sacrifice layer atop the initial metal conductive layer by oxidizing the initial metal conductive layer using oxygen plasma. The initial metal conductive layer and the metal conductive layer may be made of a material including tungsten. The initial sacrifice layer may be made of a material including tungsten oxide.

In some embodiments, the mask layer may include an amorphous carbon layer. Forming the metal conductive layer and the sacrifice layer atop the metal conductive layer by etching the initial sacrifice layer and the initial metal conductive layer using the oxygen source gas as the etching gas based on the patterned mask layer may include: forming a patterned amorphous carbon layer atop the initial sacrifice layer; and forming the metal conductive layer and the sacrifice layer atop the metal conductive layer by etching the initial sacrifice layer and the initial metal conductive layer via in-situ oxygen plasma etching based on the patterned amorphous carbon layer.

In some embodiments, removing the patterned mask layer by performing the ashing process using the oxygen source gas as the etching gas may include: removing the patterned amorphous carbon layer by performing the ashing process using oxygen plasma.

In some embodiments, the by-products formed during the etching and the ashing process may include an oxide of tungsten.

In some embodiments, removing the sacrifice layer as well as the by-products formed during the etching and the ashing process and exposing the metal conductive layer by performing the corrosion process using the alkaline corrosion solution may include: removing a natural oxide on the sacrifice layer and exposing the sacrifice layer as well as the by-products formed during the etching and the ashing process by pretreating a surface of the sacrifice layer; removing the sacrifice layer as well as the by-products formed during the etching and the ashing process using the alkaline corrosion solution, and exposing the metal conductive layer; removing the alkaline corrosion solution remaining atop the metal conductive layer; and drying the metal conductive layer.

In some embodiments, the alkaline corrosion solution may include an Ammonia Diw Mixture (ADM). A volume ratio of ammonia to deionized water in the ADM may range from 5:1 to 1000:1.

In some embodiments, the metal conductive layer is dried using isopropyl alcohol and nitrogen.

In some embodiments, forming the isolation structure between the adjacent metal conductive layers may include: forming the isolation structure by sequentially forming a first dielectric layer and a second dielectric layer between the adjacent metal conductive layers.

In some embodiments, an initial barrier layer located between the insulation layer and the initial metal conductive layer is also formed on the substrate. Forming the metal conductive layer and the sacrifice layer atop the metal conductive layer by etching the initial sacrifice layer and the initial metal conductive layer using the oxygen source gas as the etching gas based on the patterned mask layer may include: forming a groove by etching the initial sacrifice layer, the initial metal conductive layer, and the initial barrier layer using the oxygen source gas as the etching gas based on the patterned mask layer, and forming, on both sides of the groove, a barrier layer, the metal conductive layer, and the sacrifice layer stacking in sequence. Forming the isolation structure between the adjacent metal conductive layers may include: forming the isolation structure in the groove.

In some embodiments, the initial sacrifice layer is formed atop the initial metal conductive layer using a process gas including: oxygen, a hydrogen nitrogen mixture, nitrogen, and argon. The process gas may flow in at a flow rate ranging from 100 standard ml/min to 15000 standard ml/min. A pressure of a region where the oxygen plasma are produced may range from 10 mtorr to 10000 mtorr. A radio frequency power may range from 10 W to 10000 W.

In embodiments of the present disclosure, first, an insulation layer, an initial metal conductive layer, an initial sacrifice layer, and a mask layer stacking in sequence are formed on a substrate. The initial sacrifice layer may protect the initial metal conductive layer from being damaged while a patterned mask layer is subsequently removed. Secondly, the initial sacrifice layer and the initial metal conductive layer are etched using an oxygen source gas as an etching gas based on a patterned mask layer, thereby acquiring a patterned metal conductive layer as needed and a sacrifice layer atop the metal conductive layer, as well as allowing a by-product formed during the etch to include mainly a metal oxide. Thirdly, when the patterned mask layer is removed by performing an ashing process using the oxygen source gas as the etching gas, the oxygen source gas may further allow a by-product formed in the ashing process to mainly include the metal oxide. Fourthly, the sacrifice layer as well as a by-product formed during the etching and the ashing process are removed using an alkaline corrosion solution. The alkaline corrosion solution may react with the sacrifice layer and the by-product, but not with the metal conductive layer, reducing damage to the metal conductive layer. In addition, by-products formed in the etching and the ashing process as well as the sacrifice layer are all metal oxides, allowing both the sacrifice layer and the by-products to be etched and removed at one time using one solution, thereby simplifying a process flow. Finally, an isolation structure is formed between adjacent metal conductive layers, further reducing short circuit between adjacent metal conductive layers.

### BRIEF DESCRIPTION OF THE DRAWINGS

In the drawings (not necessarily plotted to scale), like reference signs may represent like parts in different views. Like reference signs with different letter suffixes may represent different examples of like parts. The drawings generally show various embodiments discussed herein in an illustrative non-limiting way.
FIG. 1 is a flowchart of a method for forming a semiconductor structure according to embodiments of the present disclosure.
FIG. 2A to FIG. 2E are diagrams of structures constituting a process for forming a semiconductor structure according to embodiments of the present disclosure.
FIG. 3A and FIG. 3B are diagrams of structures constituting a process for forming a semiconductor structure according to embodiments of the present disclosure.
FIG. 3C to FIG. 3E are diagrams of forming an initial sacrifice layer atop an initial metal conductive layer according to embodiments of the present disclosure.
FIG. 4 is a diagram of a structure constituting a process for forming a semiconductor structures according to embodiments of the present disclosure.
FIG. 5A is a flowchart of a method for forming a semiconductor structure according to embodiments of the present disclosure.
FIG. 5B to FIG. 5H are diagrams of structures constituting a process for forming a semiconductor structure according to embodiments of the present disclosure.

### DETAILED DESCRIPTION

Illustrative embodiments of the present disclosure may be elaborated below with reference to the drawings. Note that although illustrative embodiments of the present disclosure are shown in the drawings, the present disclosure may be implemented in various forms without being limited by embodiments illustrated herein. Rather, embodiments are provided to allow a thorough understanding of the present disclosure, and to deliver the complete scope of the present disclosure to a person having ordinary skill in the art.

A number of details are given in description below in order to provide a more thorough understanding of the present disclosure. However, it is clear to a person having ordinary skill in the art that the present disclosure may be implemented without one or more of the details. In other examples, in order to avoid confusion with the present disclosure, some technical features known in the art are not described. That is, not all features of an actual embodiment are described here, nor are a known function and a known structure elaborated.

In the drawings, a size as well as a relative size of a layer, a region, an element, etc., may be exaggerated for clarity. A same element is always denoted by a same reference sign.

Note that an element or layer "above", "adjacent to", "connected to", or "coupled to" another element or layer may be directly above, adjacent to, connected to, or coupled to the another element or layer, or there may be an intermediate element or layer. On the contrary, for an element or layer "direct above", "directly adjacent to", "connected direct to", or "coupled direct to" another element or layer, there is no intermediate element or layer. Note that although terms such as first, second, third, etc., are used to describe various elements, components, regions, layers, and /or parts, the elements, components, regions, layers, and /or parts should not be limited by the terms. The terms are used merely to distinguish one element, component, region, layer, or part from another element, component, region, layer, or part. Therefore, a first element, component, region, layer, or part discussed below may be denoted as a second element, component, region, layer, or part without departing from teachings of the present disclosure. Moreover, discussion of a second element, component, region, layer, or part does not necessarily indicate existence of a first element, component, region, layer, or part in the present disclosure.

A term herein is used merely to describe an embodiment and is not intended as a limitation to the present disclosure. As used herein, a singular form of "a/an", "one", and "the" is also intended to include a plural form, unless clearly indicated otherwise by the context. Note that a term "constitute" and /or "include / comprise" used in the present disclosure determines existence of a feature, integer, step, operation, element, and /or component, without excluding existence or addition of one or more other features, integers, steps, operations, elements, components, and /or groups. A term "and/or" used herein includes any and all combinations of related items listed.

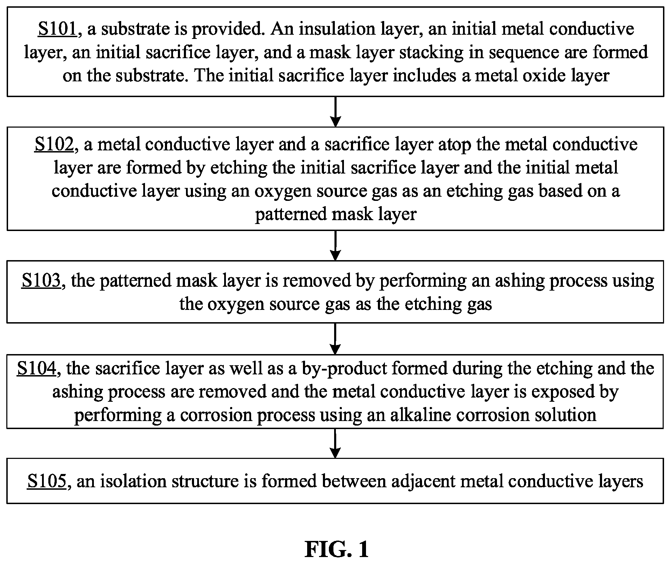

Embodiments of the present disclosure provide a method for forming a semiconductor structure. Referring to FIG. 1, the method includes S101 to S105 as follows.

In S101, a substrate is provided. An insulation layer, an initial metal conductive layer, an initial sacrifice layer, and a mask layer stacking in sequence are formed on the substrate. The initial sacrifice layer includes a metal oxide layer.

The substrate may be a silicon substrate, a Silicon-On-Insulator (SOI) substrate, etc. The substrate may also include another semiconductor element, or may include a semiconductor compound such as Silicon Carbide (SiC), Gallium Arsenide (GaAs), Gallium Phosphide (GaP), Indium Phosphide (InP), Indium Arsenide (InAs) or Indium Antimonide (InSb), or may include another semiconductor alloy such as Gallium arsenide phosphide (GaAsP), Indium Aluminum Arsenide (AllnAs), Gallium Aluminum Arsenide (AlGaAs), Indium Gallium Arsenide (GaInAs), Indium Gallium Phosphide (GalnP), and /or Indium Gallium Arsenide Phosphide (GalnAsP), or a combination thereof.

The insulation layer may be made of one or more of silicon oxide, silicon nitride, silicon nitrogen oxide, silicon carbon oxide, borosilicate glass, phosphorosilicate glass, borophosphosilicate glass, etc. The insulation layer may be formed via a process such as Chemical Vapor Deposition (CVD), Physical Vapor Deposition (PVD), Atomic Layer Deposition (ALD), etc.

The initial metal conductive layer may be made of at least one of Tungsten (W), Tantalum (Ta), Titanium (Ti), etc.

The initial sacrifice layer may serve to protect the initial metal conductive layer from being damaged during a subsequent process. The initial sacrifice layer may include a metal oxide layer. Metal contained in the initial sacrifice layer may be the same as metal contained in the initial metal conductive layer. For example, both the initial metal conductive layer and the initial sacrifice layer may contain the metal element tungsten. That is, the initial metal conductive layer may be an initial tungsten layer, and the initial sacrifice layer may be a tungsten oxide layer. Of course, the initial sacrifice layer and the initial metal conductive layer may each contain a metal element different from each other. For example, the initial metal conductive layer may be an initial tungsten layer, and the initial sacrifice layer may be a tantalum oxide layer. In embodiments of the present disclosure, material commonly used in a metal conductive layer, such as tungsten, is illustrated as an example. That is, it is described as an example that both the initial sacrifice layer and the initial metal conductive layer contain the metal element tungsten.

A specific part in the mask layer may be converted into a patterned mask layer in a subsequent process. The mask layer may be of a double-layer structure, or even a multi-layer structure, or may be of a single-layer structure. Of the double-layer or multi-layer structure, an upper mask layer may protect a lower mask layer, reducing damage to the lower mask layer, thus reducing circumstances of a defected patterned mask layer, thereby improving an effect of pattern transfer. The mask layer may be made of one or more of silicon oxide, silicon nitride, silicon carbide, silicon oxynitride, amorphous carbon, polycrystalline silicon, hafnium oxide, titanium oxide, zirconia, titanium nitride, tantalum nitride, etc. The mask layer may be formed by any one of CVD, PVD, ALD, or spin coating, or any other suitable process. A type and a number of layers of the mask layer are not limited in embodiments of the present disclosure.

In some embodiments, a photoresist layer and an anti-reflection layer may also be formed on the mask layer. In implementation, the photoresist layer may be subjected to exposure, development, fixing, etc. The anti-reflection layer and the mask layer may be etched using the remaining part of the photoresist layer. The part protected by the photoresist may be kept, forming a patterned mask layer. In this way, precision in forming a pattern in the mask layer is improved, thus improving a yield of a semiconductor device.

In S102, a metal conductive layer and a sacrifice layer atop the metal conductive layer are formed by etching the initial sacrifice layer and the initial metal conductive layer using an oxygen source gas as an etching gas based on a patterned mask layer.

Here, the oxygen source gas may include oxygen and /or ozone. In implementation, the oxygen source gas may be excited under radio frequency power, be ionized, and form plasma. Being hit by electrons, gas in a reaction chamber may be converted into ions, absorb energy, and form a massive number of active reactive groups. An active reactive group may form a chemical reaction with a surface of an etch-targeted substance (including the initial sacrifice layer and the initial metal conductive layer) and form a volatile reaction product. Then, the reaction product may disengage from the surface of the etch-targeted substance, and be pumped out of the reaction chamber by a vacuum system.

In S103, the patterned mask layer is removed by performing an ashing process using the oxygen source gas as the etching gas.

The oxygen source gas may include oxygen and /or ozone. The ashing process /treatment may refer to removal of the remaining of the photoresist, the patterned mask layer, another organic substance, etc.

Note that if a non-oxygen source gas, such as a nitrogen source gas, is used in the ashing process, then the nitrogen source gas and the metal conductive layer may produce a by-product metal nitride, such as tungsten nitride. The by-product produced during the etch mainly may include a metal oxide, which is different from the by-product produced during the ashing. The two by-products of the metal oxide and the metal nitride produced during the etching and the ashing process may not be removed subsequently at the same time using one solution. This reduces an effect of removing the by-products, and part of the by-products may remain on the metal conductive layer. In a subsequent process of cleaning the metal conductive layer, the remaining by-products may move between adjacent metal conductive layers, connecting the adjacent metal conductive layers, short circuiting the adjacent metal conductive layers, thereby reducing a yield of the semiconductor structure. Therefore, a nitrogen-free gas, such as an oxygen source gas, may have to be used in the ashing process, so that the by-products produced during the etching and the ashing are the same, allowing the by-products produced in the etching and the ashing process to be removed at one time using one solution, thereby simplifying a process flow, improving a yield of the semiconductor structure.

In S104, the sacrifice layer as well as a by-product formed during the etching and the ashing process are removed and the metal conductive layer is exposed by performing a corrosion process using an alkaline corrosion solution.

The alkaline corrosion solution may include an alkali with a pKb of less than or equal to about 5, less than or equal to about 4.8, less than or equal to about 4.75, less than or equal to about 4.7, less than or equal to about 4.5, less than or equal to about 3, less than or equal to about 2, or less than or equal to about 1. In some embodiments, the alkali may include an organic base, such as pyridine, methylamine, imidazole, hydroxides of organic cations, etc. In some embodiments, the alkali may include alkaline salts, such as sodium carbonate, sodium acetate, a compound having a weak acid component that hydrolyzes to form an alkaline solution, etc. In some embodiments, the alkali may include an alkali metal. In some embodiments, the alkali may include hydroxyl ions. In some embodiments, the alkali may include one or more of sodium hydroxide (NaOH), potassium hydroxide (KOH) or ammonium hydroxide (NH₄OH).

In embodiments of the present disclosure, the alkaline corrosion solution may include a mixture of Ammonia and deionized water (Ammonia Diw Mixture, ADM). A volume ratio of ammonia to deionized water in the ADM may range from 5:1 to 1000:1. The ADM may react with the sacrifice layer according to Formula (1). Tungsten oxide WₓO_{y} in the sacrifice layer may react with ammonium hydroxide, producing ammonium tungstate. The ammonium tungstate may dissolve in water to remove the sacrifice layer. Meanwhile, the ADM does not react with the metal conductive layer, therefore reducing damage to the metal conductive layer.

WₓO_{y} MH₄OH → (NH₄)₆W₇O₂₄•6H₂O Formula (1)

A by-product formed during the etching and the ashing process may include an oxide of tungsten WₓO_{y}. The x may be equal to 1. The y may be equal to 3. In that case, the oxide of tungsten may be tungsten trioxide.

In S105, an isolation structure is formed between adjacent metal conductive layers.

The isolation structure may serve to separate adjacent metal conductive layers, further reducing short circuit between adjacent metal conductive layers.

In embodiments of the present disclosure, first, an insulation layer, an initial metal conductive layer, an initial sacrifice layer, and a mask layer stacking in sequence are formed on a substrate. The initial sacrifice layer may protect the initial metal conductive layer from being damaged while a patterned mask layer is subsequently removed. Secondly, the initial sacrifice layer and the initial metal conductive layer are etched using an oxygen source gas as an etching gas based on a patterned mask layer, thereby acquiring a patterned metal conductive layer as needed and a sacrifice layer atop the metal conductive layer, as well as allowing a by-product formed during the etch to include mainly a metal oxide. Thirdly, when the patterned mask layer is removed by performing an ashing process using the oxygen source gas as the etching gas, the oxygen source gas may further allow a by-product formed in the ashing process to mainly include the metal oxide. Fourthly, the sacrifice layer as well as a by-product formed during the etching and the ashing process are removed using an alkaline corrosion solution. The alkaline corrosion solution may react with the sacrifice layer and the by-product, but not with the metal conductive layer, reducing damage to the metal conductive layer. In addition, by-products formed in the etching and the ashing process as well as the sacrifice layer are all metal oxides, allowing both the sacrifice layer and the by-products to be etched and removed at one time using one solution, thereby simplifying a process flow. Finally, an isolation structure is formed between adjacent metal conductive layers, further reducing short circuit between adjacent metal conductive layers.

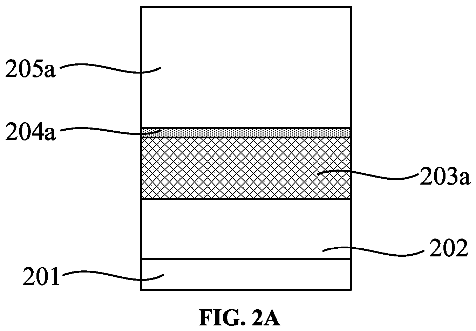

S101 to S105 are further described below with reference to FIG. 2A to FIG. 2E.

Referring to FIG. 2A, an insulation layer 202, an initial metal conductive layer 203a, an initial sacrifice layer 204a, and a mask layer 205a stacking in sequence are formed on a substrate 201. The initial sacrifice layer 204a includes a metal oxide layer.

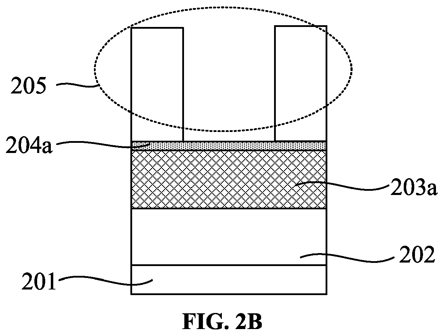

Referring to FIG. 2B, a patterned mask layer 205 may be formed atop the initial sacrifice layer 204a. It may be seen that the patterned mask layer 205 exposes part of the initial sacrifice layer 204a, and defines a location targeted by subsequent etch.

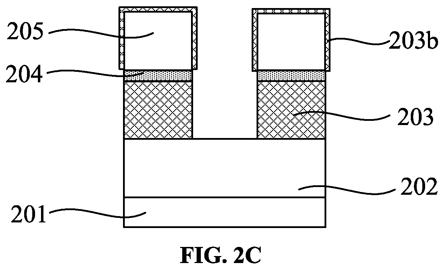

Referring to both FIG. 2B and FIG. 2C, a metal conductive layer 203 and a sacrifice layer 204 located atop the metal conductive layer 203 are formed by etching the initial sacrifice layer 204a and the initial metal conductive layer 203a using an oxygen source gas as an etching gas based on a patterned mask layer 205. Part of the patterned mask layer 205 may be consumed during the etch. Therefore, it may be seen that the patterned mask layer 205 in FIG. 2C is less thick than the patterned mask layer 205 in FIG. 2B. In implementation, referring to FIG. 2C, during the etch, the initial metal conductive layer 203b removed by the etch may again deposit on an upper surface and a side wall of the patterned mask layer 205. Part of the initial metal conductive layer 203b may be oxidized into a metal oxide (such as tungsten oxide), forming a by-product of the etch. The initial metal conductive layer 203b not oxidized during the etch may be further oxidized in the ashing process, forming a by-product of the ashing process.

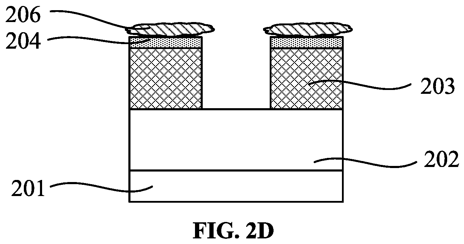

Referring to both FIG. 2C and FIG. 2D, the patterned mask layer 205 is removed by performing an ashing process using the oxygen source gas as the etching gas, forming a by-product 206 on the sacrifice layer 204. In implementation, the by-product 206 may also be located between adjacent metal conductive layers 203.

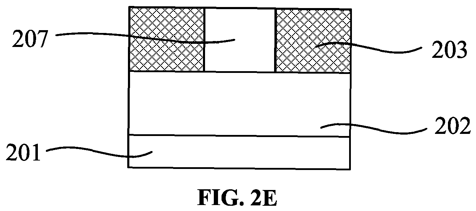

Referring to both FIG. 2D and FIG. 2E, the sacrifice layer 204 as well as a by-product 206 formed during the etching and the ashing process are removed and the metal conductive layer 203 is exposed by performing a corrosion process using an alkaline corrosion solution. An isolation structure 207 is formed between adjacent metal conductive layers 203.

In some embodiments, an etch time, defined as when the etch eats up the depth of the initial metal conductive layer 203a and just yet reaches the insulation layer 202, may be acquired according to an etch rate and an etch depth. A structure as shown in FIG. 2C may be acquired by the etch based on the etch time. In some other embodiments, part of the insulation layer may be eaten in the etch without considering the etch time (i.e., overetch), where the insulation layer may serve as a layer where the etch stops, simplifying a process flow.

Based on the method for forming a semiconductor structure provided by S101 to S105, embodiments of the present disclosure provide a semiconductor structure. Referring to FIG. 2E, the semiconductor structure includes: a substrate, a metal conductive layer, and an isolation structure.

An insulation layer 202 is formed on the substrate 201.

The metal conductive layer 203 is located atop the insulation layer 202.

The isolation structure 207 is located between adjacent metal conductive layers 203.

In embodiments of the present disclosure, the semiconductor structure formed by the abovementioned method includes a substrate, a metal conductive layer and an insulation layer located atop the substrate, and an isolation structure located between metal conductive layers. In one aspect, in forming the semiconductor structure, an oxygen source gas is used as an etching gas in the etch and the ashing process, so that both by-products of the etch and the ashing process mainly include a metal oxide, rather than the case where the by-product of the etch mainly includes the metal oxide and the by-product of the ashing process mainly includes a metal oxide. Therefore, the by-products of the etching and the ashing process may be removed at one time using one solution, improving an effect of removing the by-products while simplifying a process flow, further reducing short circuit caused by any by-product remaining between adjacent metal conductive layers, ultimately improving a yield of the semiconductor structure. In another aspect, in forming the semiconductor structure, as the sacrifice layer is a metal oxide layer, and the by-products of the etching and the ashing process are also metal oxides, the sacrifice layer and the by-products may be removed at one time using one solution, allowing a simple flow of forming the semiconductor structure.

In some embodiments, the initial sacrifice layer may be formed by a method including S11 to S12.

In S11, a planarization process may be performed on the initial metal conductive layer.

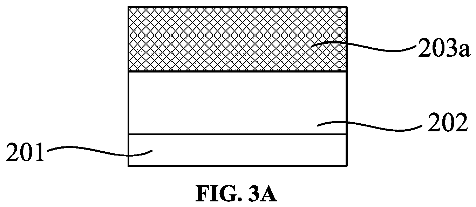

Referring to FIG. 3A, planarization may be performed on the initial metal conductive layer 203a via Chemical Mechanical Polishing (CMP), acquiring a flat surface with no scratch nor impuriy, facilitating subsequent formation of the initial sacrificial surface.

In S12, the initial sacrifice layer may be formed atop the initial metal conductive layer by oxidizing the initial metal conductive layer using oxygen plasma. The initial metal conductive layer and the metal conductive layer may be made of a material including tungsten. The initial sacrifice layer may be made of a material including tungsten oxide.

In some embodiments, the initial sacrifice layer may be formed atop the initial metal conductive layer using a process gas including: oxygen, a hydrogen nitrogen mixture, nitrogen, argon, etc. The process gas may flow in at a flow rate ranging from 100 standard milliliter per minute (ml/min) to 15000 standard ml/min. A pressure of a region where the oxygen plasma are produced may range from 10 mtorr to 10000 mtorr. A radio frequency power may range from 10 W to 10000 W.

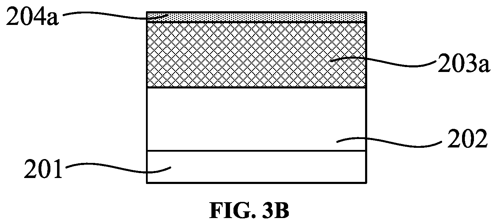

Referring to FIG. 3B, the initial metal conductive layer 203a may be oxidized using oxygen plasma, oxidizing part of the initial metal conductive layer 203a, thereby forming the initial sacrifice layer 204a atop the initial metal conductive layer 203a. When the initial metal conductive layer is made of tungsten, a chemical reaction occurred in the oxidation process may be as shown in Formula (2), i.e, tungsten may react with oxygen as well as oxygen plasma, producing tungsten oxide WₓO_{y}.

W + O₂/O*→WₓO_{y} Formula (2)

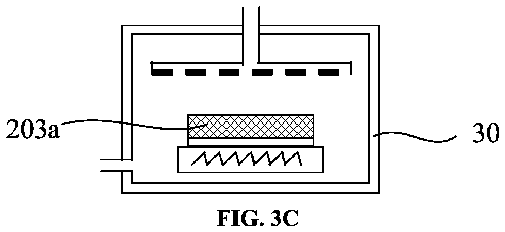

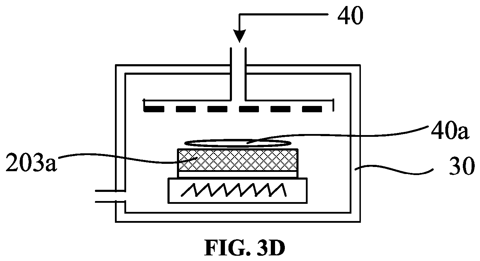

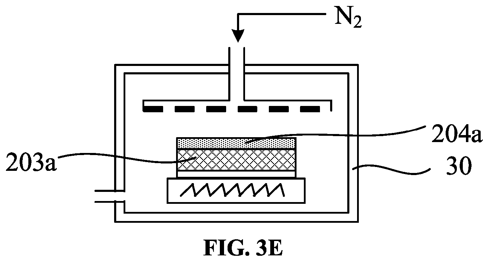

In implementation, first, referring to FIG. 3C, a structure subjected to the planarization process may be preheated in a reaction chamber. Secondly, referring to FIG. 3D, a process gas, such as oxygen, a hydrogen nitrogen mixture, nitrogen, etc., may be introduced into the reaction chamber 30. Oxygen plasma 40a may gather atop the initial metal conductive layer 203a, so that the oxygen plasma 40a may react with the initial metal conductive layer 203a, producing an initial sacrifice layer 204a. Then, referring to FIG. 3E, introduction of nitrogen into the reaction chamber 30 may continue, allowing the structure with the initial sacrifice layer 204a formed to cool to room temperature. Finally, introduction of nitrogen may continue, and the structure with the initial sacrifice layer formed may be taken out.

In embodiments of the present disclosure, planarization may be performed on the initial metal conductive layer. Part of the initial metal conductive layer may be oxidized using oxygen plasma, allowing formation of a uniform oxide film (i.e., the initial sacrifice layer). In this way, in one aspect, uniformity of the initial sacrifice layer is improved, improving quality of the initial sacrifice layer. In another aspect, after the initial conductive layer is formed, the initial sacrifice layer is formed by oxidizing the initial metal conductive layer using oxygen plasma. That is, formation of the initial sacrifice layer is an incident of formation of the initial conductive layer, instead of a result of resorting to a dedicated process such as deposition or spin coating, etc., therefore simplifying a process flow.

In some embodiments, the mask layer may include an amorphous carbon layer. In S102, the metal conductive layer and the sacrifice layer atop the metal conductive layer may be formed by etching the initial sacrifice layer and the initial metal conductive layer using the oxygen source gas as the etching gas based on the patterned mask layer as follows, which may include S1021 and S1022.

In S1021, a patterned amorphous carbon layer may be formed atop the initial sacrifice layer.

In S1022, the metal conductive layer and the sacrifice layer atop the metal conductive layer may be formed by etching the initial sacrifice layer and the initial metal conductive layer via in-situ oxygen plasma etching based on the patterned amorphous carbon layer.

Correspondingly, in S103, the patterned mask layer may be removed by performing the ashing process using the oxygen source gas as the etching gas as follows.

In S1031, the patterned amorphous carbon layer may be removed by performing the ashing process using oxygen plasma.

In embodiments of the present disclosure, the mask layer may include an amorphous carbon layer. In in-situ oxygen plasma etching, the oxygen plasma may react with amorphous carbon, producing carbon dioxide, thus removing part of the patterned amorphous carbon layer. Amorphous carbon is of high etch selectivity with respect to the metal conductive layer and the sacrifice layer, therefore reducing damage to the metal conductive layer in the subsequent ashing process using the oxygen source gas as the etching gas.

In some embodiments, in S104, the sacrifice layer as well as the by-product formed during the etching and the ashing process may be removed and the metal conductive layer may be exposed by performing the corrosion process using the alkaline corrosion solution as follows, which may include S1041 to S1044.

In S1041, a natural oxide on the sacrifice layer may be removed and the sacrifice layer as well as the by-product formed during the etching and the ashing process may be exposed by pretreating a surface of the sacrifice layer.

The surface of the sacrifice layer may be pretreated as follows. The surface of the sacrifice layer may be wetted. The surface of the sacrifice layer may be cleaned with a small amount of Diluted Hydrofluoric Acid (DHF), removing the natural oxide and some dust impurity particles on the sacrifice layer, thereby exposing the sacrifice layer as well as the by-product formed during the etching and the ashing process, facilitating subsequent removal of the by-product.

In some embodiments, a volume ratio of hydrogen fluoride to deionized water in a mixture of hydrogen fluoride and deionized water may range from 10:1 to 1000:1. In embodiments of the present disclosure, the range of the volume ratio of hydrogen fluoride to deionized water in the mixture of hydrogen fluoride and deionized water is set, improving a rate of removing the natural oxide atop the sacrifice layer.

In S1042, the sacrifice layer as well as the by-product formed during the etching and the ashing process may be removed using the alkaline corrosion solution, and the metal conductive layer may be exposed.

In S1043, the alkaline corrosion solution remaining atop the metal conductive layer may be removed.

Here, the alkaline corrosion solution remaining atop the metal conductive layer may be removed using deionized water. Alternatively, the alkaline corrosion solution may first be neutralized by excess acid solution, and then the remaining acid solution may be removed using deionized water. The acid solution used may not damage the surface of the metal conductive layer.

In S1044, the metal conductive layer may be dried.

With continuous reduction of a line width of a semiconductor manufacturing process, as in centrifugal drying, liquid has to be made disappear from a surface under the action of a centrifugal force in a high-speed rotating state, this may increase a risk of semiconductor structure collapse. In embodiments of the present disclosure, in order to reduce the risk of semiconductor structure collapse, the metal conductive layer may be dried using Isopropyl Alcohol (IPA). In implementation, the metal conductive layer may be dried in a nitrogen atmosphere, reducing a chance of the metal conductive layer being oxidized again by oxygen in the air, thereby reducing impact on conductivity of the metal conductive layer.

Drying in IPA may be performed as follows. With IPA drying, dehydration and drying is achieved via vaporization and evaporation through IPA heating, as well as the action of surface tension. An IPA steam system may include a steam tank, a steam region, and a condensation tank. IPA in the steam tank may form steam under the action of a heater. The steam may go upward, forming a steam region with stable concentration and temperature. A top layer may be a condensation region made up of cooling water pipes.

Before being dried, the metal conductive layer may have to be immersed in an IPA liquid. Water atop the metal conductive layer may dissolve into the IPA due to intersolubility, thus liquid IPA in place. The metal conductive layer may be raised or lowered in the system through a chain. When arriving at the steam region, steam may condense on the surface due to low temperature of the metal conductive layer, forming a massive amount of liquid IPA rinsing the surface. After the temperature of the metal conductive layer rises, the metal conductive layer carrying the IPA steam may return to the condensation region. The IPA steam may condense and liquefy, and leave the surface under actions such as gravity, surface tension, volatilization, etc., thereby achieving a drying effect.

In some other embodiments, the metal conductive layer may be dried by Marangoni drying technology. Marangoni drying differs from IPA drying essentially in that Marangoni drying is achieved by puling water back to a water surface through surface tension gradient, and IPA drying is achieved by evaporation of water. Marangoni drying not only reduces the amount of IPA used, but also overcomes difficulty in dehydrating a deep narrow channel.

In S105, the isolation structure may be formed between the adjacent metal conductive layers as follows. The isolation structure may be formed by sequentially forming a first dielectric layer and a second dielectric layer between the adjacent metal conductive layers.

The first dielectric layer may be made of insulation material such as silicon nitride, silicon oxide, etc. The second dielectric layer may be made of silicon nitride or silicon oxide doped with impurities such as fluorine, carbon, boron, etc. The impurity ions may lower a dielectric constant of the silicon nitride or the silicon oxide, thus lowering a parasitic capacitance between metal conductive layers, thereby lowering power consumption of a device.

The first dielectric layer may be formed by CVD, PVD, ALD, Low Pressure Chemical Vapor Deposition (LPCVD), plasma enhanced chemical vapor deposition (PECVD), spin coating, or any other suitable process. The second dielectric layer may be acquired by first forming a dielectric layer through CVD, then doping the dielectric layer with impurity ions through an ion doping process, and finally annealing the dielectric layer doped with the impurity ions.

In embodiments of the present disclosure, the isolation structure is formed by sequentially forming the first dielectric layer and the second dielectric layer at the metal conductive layers. That is, the isolation structure formed includes the first dielectric layer and the second dielectric layer, so that the two different dielectric layers both serve the function of isolation, therefore improving performance of separation by the isolation structure.

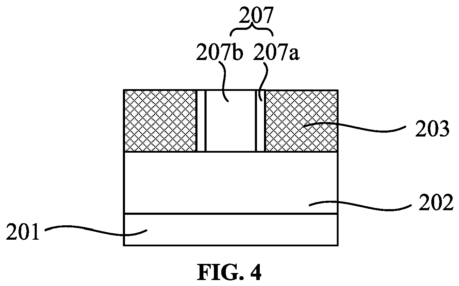

Referring to FIG. 4, the isolation structure may be formed by sequentially forming a first dielectric layer 207a and a second dielectric layer 207b between the adjacent metal conductive layers 203. It may be seen that the first dielectric layer 207a is formed on both a right side wall of the metal conductive layer 203 on the left and a left side wall of the metal conductive layer 203 on the right, and the second dielectric layer 207b fills the remaining space between the metal conductive layers 203.

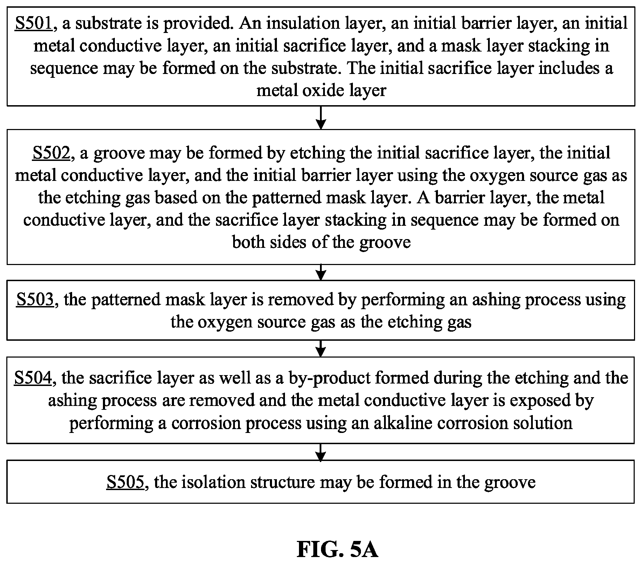

Embodiments of the present disclosure further provide a method for forming a semiconductor structure. Referring to FIG. 5A, the method includes S501 to S505.

In S501, a substrate is provided. An insulation layer, an initial barrier layer, an initial metal conductive layer, an initial sacrifice layer, and a mask layer stacking in sequence may be formed on the substrate. The initial sacrifice layer includes a metal oxide layer.

Here, the initial barrier layer located between the insulation layer and the initial metal conductive layer is also formed on the substrate. The initial barrier layer may prevent metal in the initial metal conductive layer from diffusing into the insulation layer.

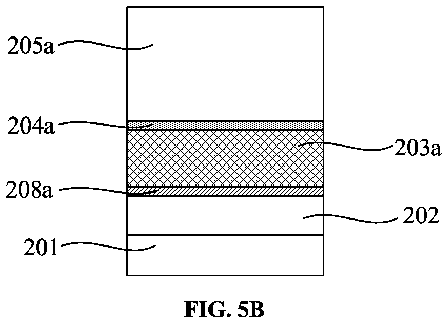

Referring to FIG. 5B, an insulation layer 202, an initial barrier layer 208a, an initial metal conductive layer 203a, an initial sacrifice layer 204a, and a mask layer 205a stacking in sequence may be formed on the substrate 201. The insulation layer 202 may be a silicon nitride layer. The initial metal conductive layer 203a may be an initial tungsten layer. The initial sacrifice layer 204a may be a tungsten oxide layer. The initial barrier layer 208a may be a titanium nitride layer. The mask layer 205a may be an amorphous carbon layer.

In S502, a groove may be formed by etching the initial sacrifice layer, the initial metal conductive layer, and the initial barrier layer using the oxygen source gas as the etching gas based on the patterned mask layer. A barrier layer, the metal conductive layer, and the sacrifice layer stacking in sequence may be formed on both sides of the groove.

The metal conductive layer may be made of material including tungsten.

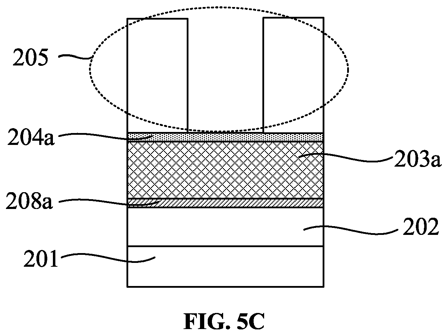

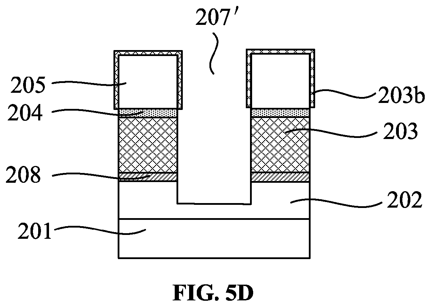

Referring to FIG. 5C, a patterned mask layer 205 may be formed on the initial sacrifice layer 204a. Referring to FIG. 5C and FIG. 5D, a groove 207' may be formed by etching the initial sacrifice layer 204a, the initial metal conductive layer 203a, and the initial barrier layer 208a using the oxygen source gas as the etching gas based on the patterned mask layer 205, in addition to etching part of the insulation layer 202. A barrier layer 208, the metal conductive layer 203, and the sacrifice layer 204 stacking in sequence may be formed on both sides of the groove 207'. Here, the depth of the groove 207' may be less than a sum of thicknesses of the barrier layer, the metal conductive layer, the sacrifice layer, and the insulation layer.

In some embodiments, the depth of the groove 207' may be equal to the sum of thicknesses of the barrier layer, the metal conductive layer, and the sacrifice layer.

In S503, the patterned mask layer is removed by performing an ashing process using the oxygen source gas as the etching gas.

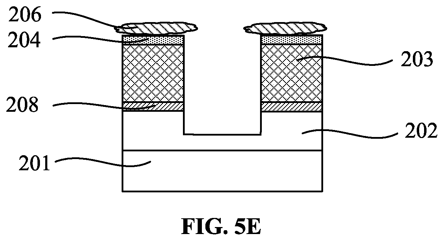

Referring to both FIG. 5D and FIG. 5E, the patterned mask layer 205 is removed by performing an ashing process using the oxygen source gas as the etching gas. The by-product 206 formed during the etching and the ashing process may be attached to the surface of the sacrifice layer 204.

In S504, the sacrifice layer as well as a by-product formed during the etching and the ashing process are removed and the metal conductive layer is exposed by performing a corrosion process using an alkaline corrosion solution.

Both the sacrifice layer and the by-product may be tungsten oxide, allowing to remove the sacrifice layer and the by-product at one time.

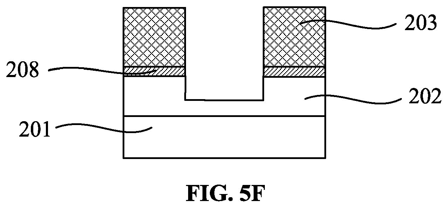

Referring to both FIG. 5E and FIG. 5F, the sacrifice layer 204 as well as the by-product 206 formed during the etching and the ashing process are removed and the metal conductive layer 203 is exposed by performing a corrosion process using an alkaline corrosion solution.

S503 and S504 may be implemented with reference to S103 and S104, respectively.

In S505, the isolation structure may be formed in the groove.

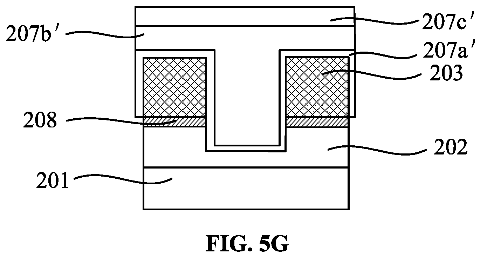

Referring to FIG. 5G, first, a first dielectric layer material 207a' may be deposited in the groove by ALD, improving flatness and quality of the subsequently formed dielectric layer. Then, a second dielectric layer material 207b' may be deposited by plasma enhanced chemical deposition. The second dielectric layer material 207b' may fill the remaining space of the groove. As an ALD process needs more time than a plasma enhanced chemical deposition process for depositing dielectric material of the same thickness, time for forming the isolation structure may be reduced using the plasma enhanced chemical deposition process. After the second dielectric layer material 207b' is deposited, the second dielectric layer material 207b' may be doped with impurity ions, reducing the dielectric constant of the second dielectric layer material 207b'. Finally, a third dielectric layer material 207c' may be deposited on the second dielectric layer material 207b' by LPCVD. In this way, as an LPCVD process needs needs less time than the plasma enhanced chemical deposition process for depositing dielectric material of the same thickness, time for forming the isolation structure may further be reduced. Thus, in case the isolation structure has a preset height, on one hand, not only quality of a dielectric layer in the isolation structure is improved, but also time for forming the isolation structure is reduced. On the other hand, as the lower the dielectric constant of the dielectric layer between adjacent metal conductive layers, the less a parasitic capacitance between the adjacent metal conductive layers, the parasitic capacitance between adjacent metal conductive layers is reduced by reducing the dielectric constant of the second dielectric layer material, thereby reducing power consumption of a device.

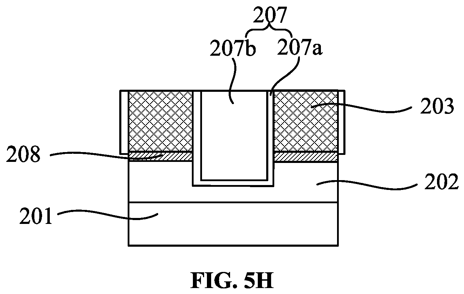

Referring to FIG. 5H, the isolation structure 207 may be formed by removing the dielectric layer material above the metal conductive layer 203. The isolation structure 207 may include the first dielectric layer 207a located at both sides of the metal conductive layer 203 (as well as at the bottom of the groove), and the second dielectric layer 207b in contact with the first dielectric layer 207a. It is seen from FIG. 5H that the first dielectric layer 207a and the second dielectric layer 207b may fill a gap between the adjacent metal conductive layers 203.

Based on the method for forming a semiconductor structure provided by S501 to S505, embodiments of the present disclosure provide a semiconductor structure. Referring to FIG. 5H, the semiconductor structure may further include a barrier layer 208 located between the insulation layer 202 and the metal conductive layer 203.

In several embodiments provided by the present disclosure, it is to be understood that a structure and method disclosed may be implemented in a non-target mode. A structure embodiment described is merely illustrative. For example, division of the units is merely division of logic functions, and there may be another mode of division in actual implementation. For example, a plurality of units or components may be combined or integrated into another system, or some features may be ignored or not implemented. Furthermore, inter-coupling or direct coupling of compoments illustrated or discussed.

The units described as separate components may or may not be physically separated. Components shown as units may be or may not be physical units. They may be located in one place, or distributed on multiple network units. Some or all of the units may be selected to achieve the purpose of a solution of the present embodiments as needed.

Features disclosed in method or structure embodiments provided by the present disclosure may be combined with each other as needed to acquire a new method or structure embodiment, as long as no conflict results from the combination.

What described are but some implementations of embodiments of the present disclosure and are not intended to limit the scope of embodiments of the present disclosure. Any modification, replacement, and/or the like made within the technical scope of embodiments of the present disclosure, as may easily occur to a person having ordinary skill in the art, shall be included in the scope of embodiments of the present disclosure. The scope of embodiments of the present disclosure thus should be determined by the claims.

### Industrial Applicability

In embodiments of the present disclosure, first, an insulation layer, an initial metal conductive layer, an initial sacrifice layer, and a mask layer stacking in sequence are formed on a substrate. The initial sacrifice layer may protect the initial metal conductive layer from being damaged while a patterned mask layer is subsequently removed. Secondly, the initial sacrifice layer and the initial metal conductive layer are etched using an oxygen source gas as an etching gas based on a patterned mask layer, thereby acquiring a patterned metal conductive layer as needed and a sacrifice layer atop the metal conductive layer, as well as allowing a by-product formed during the etch to include mainly a metal oxide. Thirdly, when the patterned mask layer is removed by performing an ashing process using the oxygen source gas as the etching gas, the oxygen source gas may further allow a by-product formed in the ashing process to mainly include the metal oxide. Fourthly, the sacrifice layer as well as a by-product formed during the etching and the ashing process are removed using an alkaline corrosion solution. The alkaline corrosion solution may react with the sacrifice layer and the by-product, but not with the metal conductive layer, reducing damage to the metal conductive layer. In addition, by-products formed in the etching and the ashing process as well as the sacrifice layer are all metal oxides, allowing both the sacrifice layer and the by-products to be etched and removed at one time using one solution, thereby simplifying a process flow. Finally, an isolation structure is formed between adjacent metal conductive layers, further reducing short circuit between adjacent metal conductive layers.

## Claims

1. A method for forming a semiconductor structure, comprising:
providing (S101) a substrate (201), wherein an insulation layer (202), an initial metal conductive layer (203a), an initial sacrifice layer (204a), and a mask layer (205a) stacking in sequence are formed on the substrate (201), wherein the initial sacrifice layer (204a) comprises a metal oxide layer;
forming (S102) a metal conductive layer (203) and a sacrifice layer (204) atop the metal conductive layer (203) by etching the initial sacrifice layer (204a) and the initial metal conductive layer (203a) using an oxygen source gas as an etching gas based on a patterned mask layer (205), as well as allowing a first by-product formed during the etching to mainly include a metal oxide;
removing (S103, S503) the patterned mask layer (205) by performing an ashing process using the oxygen source gas as the etching gas, the oxygen source gas further allowing a second by-product formed in the ashing process to mainly include a metal oxide;
removing (S104, S504) the sacrifice layer (204) as well as by-products (206) including the first by-product formed during the etching and the second by-product formed during the ashing process and exposing the metal conductive layer (203) by performing a corrosion process using an alkaline corrosion solution; and
forming (S105) an isolation structure (207) between adjacent metal conductive layers (203).

2. The method of claim 1, wherein the initial sacrifice layer (204a) is formed by:
performing a planarization process on the initial metal conductive layer (203a); and
forming the initial sacrifice layer (204a) atop the initial metal conductive layer (203a) by oxidizing the initial metal conductive layer (203a) using oxygen plasma (40a),
wherein the initial metal conductive layer (203a) and the metal conductive layer (203) are made of a material comprising tungsten, wherein the initial sacrifice layer (204a) is made of a material comprising tungsten oxide.

3. The method of claim 1, wherein the mask layer (205a) comprises an amorphous carbon layer, wherein forming the metal conductive layer (203) and the sacrifice layer (204) atop the metal conductive layer (203) by etching the initial sacrifice layer (204a) and the initial metal conductive layer (203a) using the oxygen source gas as the etching gas based on the patterned mask layer (205) comprises:
forming a patterned amorphous carbon layer atop the initial sacrifice layer (204a); and
forming the metal conductive layer (203) and the sacrifice layer (204) atop the metal conductive layer (203) by etching the initial sacrifice layer (204a) and the initial metal conductive layer (203a) via in-situ oxygen plasma (40a) etching based on the patterned amorphous carbon layer.

4. The method of claim 3, wherein removing the patterned mask layer (205) by performing the ashing process using the oxygen source gas as the etching gas comprises:
removing the patterned amorphous carbon layer by performing the ashing process using oxygen plasma (40a).

5. The method of any one of claims 1 to 4, wherein the by-products (206) formed during the etching and the ashing process comprises an oxide of tungsten.

6. The method of any one of claims 1 to 4, wherein removing the sacrifice layer (204) as well as the by-products (206) formed during the etching and the ashing process and exposing the metal conductive layer (203) by performing the corrosion process using the alkaline corrosion solution comprises:
removing a natural oxide on the sacrifice layer (204) and exposing the sacrifice layer (204) as well as the by-products (206) formed during the etching and the ashing process by pretreating a surface of the sacrifice layer (204);
removing the sacrifice layer (204) as well as the by-products (206) formed during the etching and the ashing process using the alkaline corrosion solution, and exposing the metal conductive layer (203);
removing the alkaline corrosion solution remaining atop the metal conductive layer (203); and
drying the metal conductive layer (203).

7. The method of any one of claims 1 to 4, wherein the alkaline corrosion solution comprises an Ammonia Diw Mixture (ADM), wherein a volume ratio of ammonia to deionized water in the ADM ranges from 5:1 to 1000:1.

8. The method of claim 6, wherein the metal conductive layer (203) is dried using isopropyl alcohol and nitrogen.

9. The method of any one of claims 1 to 4, wherein forming the isolation structure (207) between the adjacent metal conductive layers (203) comprises:
forming the isolation structure (207) by sequentially forming a first dielectric layer (207a) and a second dielectric layer (207b) between the adjacent metal conductive layers (203).

10. The method of claim 1, wherein an initial barrier layer (208a) located between the insulation layer (202) and the initial metal conductive layer (203a) is also formed (S501) on the substrate (201),
wherein forming (S102) the metal conductive layer (203) and the sacrifice layer (204) atop the metal conductive layer (203) by etching the initial sacrifice layer (204a) and the initial metal conductive layer (203a) using the oxygen source gas as the etching gas based on the patterned mask layer (205) comprises:
forming (S502) a groove (207') by etching the initial sacrifice layer (204a), the initial metal conductive layer (203a), and the initial barrier layer (208a) using the oxygen source gas as the etching gas based on the patterned mask layer (205), and forming, on both sides of the groove (207'), a barrier layer (208), the metal conductive layer (203), and the sacrifice layer (204) stacking in sequence,
wherein forming (S105) the isolation structure (207) between the adjacent metal conductive layers (203) comprises: forming (S505) the isolation structure (207) in the groove (207').

11. The method of claim 2, wherein the initial sacrifice layer (204a) is formed atop the initial metal conductive layer (203a) using a process gas comprising: oxygen, a hydrogen nitrogen mixture, nitrogen, and argon, wherein the process gas flows in at a flow rate ranging from 100 standard ml/min to 15000 standard ml/min, wherein a pressure of a region where the oxygen plasma (40a) are produced ranges from 10 mtorr to 10000 mtorr, wherein a radio frequency power ranges from 10 W to 10000 W.

## Patentansprüche

1. Verfahren zum Herstellen einer Halbleiterstruktur, umfassend:
Bereitstellen (S101) eines Substrats (201), wobei eine Isolationsschicht (202), eine anfängliche metallische leitende Schicht (203a), eine anfängliche Opferschicht (204a) und eine Maskenschicht (205a), die in Abfolge gestapelt sind, auf dem Substrat (201) gebildet sind, wobei die anfängliche Opferschicht (204a) eine Metalloxidschicht umfasst;
Bilden (S102) einer metallischen leitenden Schicht (203) und einer Opferschicht (204) auf der metallischen leitenden Schicht (203) durch Ätzen der anfänglichen Opferschicht (204a) und der anfänglichen metallischen leitenden Schicht (203a) unter Verwendung eines Sauerstoffquellengases als Ätzgas basierend auf einer gemusterten Maskenschicht (205), sowie Ermöglichen, dass ein erstes während des Ätzens gebildetes Nebenprodukt hauptsächlich ein Metalloxid beinhaltet;
Entfernen (S103, S503) der strukturierten Maskenschicht (205) durch Durchführen eines Veraschungsprozesses unter Verwendung des Gases der Sauerstoffquelle als Ätzgas, wobei das Gas der Sauerstoffquelle ferner ermöglicht, dass ein zweites Nebenprodukt, das in dem Veraschungsprozess gebildet wird, hauptsächlich ein Metalloxid beinhaltet;
Entfernen (S104, S504) der Opferschicht (204) sowie von Nebenprodukten (206), einschließlich des ersten Nebenprodukts, das während des Ätzens gebildet wird, und des zweiten Nebenprodukts, das während des Veraschungsprozesses gebildet wird, und Freilegen der metallischen leitenden Schicht (203) durch Durchführen eines Korrosionsprozesses unter Verwendung einer alkalischen Korrosionslösung; und
Bilden (S105) einer Isolationsstruktur (207) zwischen benachbarten metallischen leitenden Schichten (203).

2. Verfahren nach Anspruch 1, wobei die anfängliche Opferschicht (204a) gebildet wird durch:
Durchführen eines Planarisierungsprozesses auf der anfänglichen metallischen leitenden Schicht (203a); und
Bilden der anfänglichen Opferschicht (204a) auf der anfänglichen metallischen leitenden Schicht (203a) durch Oxidieren der anfänglichen metallischen leitenden Schicht (203a) unter Verwendung von Sauerstoffplasma (40a),
wobei die anfängliche metallische leitende Schicht (203a) und die metallische leitende Schicht (203) aus einem Wolfram umfassenden Material gefertigt sind, wobei die anfängliche Opferschicht (204a) aus einem Wolframoxid umfassenden Material gefertigt ist.

3. Verfahren nach Anspruch 1, wobei die Maskenschicht (205a) eine amorphe Kohlenstoffschicht umfasst, wobei ein Bilden der metallischen leitenden Schicht (203) und der Opferschicht (204) auf der metallischen leitenden Schicht (203) durch Ätzen der anfänglichen Opferschicht (204a) und der anfänglichen metallischen leitenden Schicht (203a) unter Verwendung des Sauerstoffquellengases als Ätzgas basierend auf der strukturierten Maskenschicht (205) Folgendes umfasst:
Bilden einer strukturierten amorphen Kohlenstoffschicht auf der anfänglichen Opferschicht (204a); und
Bilden der metallischen leitenden Schicht (203) und der Opferschicht (204) auf der metallischen leitenden Schicht (203) durch Ätzen der anfänglichen Opferschicht (204a) und der anfänglichen metallischen leitenden Schicht (203a) mittels *in-situ*-Sauerstoffplasma-Ätzen (40a) basierend auf der strukturierten amorphen Kohlenstoffschicht.

4. Verfahren nach Anspruch 3, wobei ein Entfernen der strukturierten Maskenschicht (205) durch Durchführen des Veraschungsprozesses unter Verwendung des Sauerstoffquellengases als Ätzgas Folgendes umfasst:
Entfernen der strukturierten amorphen Kohlenstoffschicht durch Veraschung mittels Sauerstoffplasma (40a).

5. Verfahren nach einem der Ansprüche 1 bis 4, wobei die Nebenprodukte (206), die während des Ätz- und Veraschungsprozesses gebildet werden, ein Wolframoxid umfassen.

6. Verfahren nach einem der Ansprüche 1 bis 4, wobei ein Entfernen der Opferschicht (204) sowie der während des Ätz- und des Veraschungsprozesses gebildeten Nebenprodukte (206) und ein Freilegen der metallischen leitenden Schicht (203) durch Ausführen des Korrosionsprozesses unter Verwendung der alkalischen Korrosionslösung Folgendes umfasst:
Entfernen eines natürlichen Oxids auf der Opferschicht (204) und Freilegen der Opferschicht (204) und der während des Ätz- und Veraschungsprozesses gebildeten Nebenprodukte (206) durch Vorbehandeln einer Oberfläche der Opferschicht (204);
Entfernen der Opferschicht (204) sowie der während des Ätz- und Veraschungsprozesses gebildeten Nebenprodukte (206) unter Verwendung der alkalischen Korrosionslösung und Freilegen der metallischen leitenden Schicht (203);
Entfernen der auf der metallischen leitenden Schicht (203) verbliebenen alkalischen Korrosionslösung; und
Trocknen der metallischen leitenden Schicht (203).

7. Verfahren nach einem der Ansprüche 1 bis 4, wobei die alkalische Korrosionslösung ein Ammoniak-Diw-Gemisch (ADM) umfasst, wobei das Volumenverhältnis von Ammoniak zu entionisiertem Wasser in dem ADM in einem Bereich von 5:1 bis 1000:1 ist.

8. Verfahren nach Anspruch 6, wobei die metallische leitende Schicht (203) unter Verwendung von Isopropylalkohol und Stickstoff getrocknet wird.

9. Verfahren nach einem der Ansprüche 1 bis 4, wobei ein Bilden der Isolationsstruktur (207) zwischen den benachbarten metallischen leitenden Schichten (203) Folgendes umfasst:
Bilden der Isolationsstruktur (207) durch aufeinanderfolgendes Bilden einer ersten dielektrischen Schicht (207a) und einer zweiten dielektrischen Schicht (207b) zwischen den benachbarten metallischen leitenden Schichten (203).

10. Verfahren nach Anspruch 1, wobei eine anfängliche Sperrschicht (208a), die sich zwischen der Isolierschicht (202) und der anfänglichen metallischen leitenden Schicht (203a) befindet, auch auf dem Substrat (201) gebildet wird (S501),
wobei das Ausbilden (S102) der metallischen leitenden Schicht (203) und der Opferschicht (204) auf der metallischen leitenden Schicht (203) durch Ätzen der anfänglichen Opferschicht (204a) und der anfänglichen metallischen leitenden Schicht (203a) unter Verwendung des Sauerstoffquellengases als Ätzgas basierend auf der strukturierten Maskenschicht (205) Folgendes umfasst:
Bilden (S502) einer Rille (207') durch Ätzen der anfänglichen Opferschicht (204a), der anfänglichen metallischen leitenden Schicht (203a) und der anfänglichen Barriereschicht (208a) unter Verwendung des Gases der Sauerstoffquelle als Ätzgas basierend auf der gemusterten Maskenschicht (205), und Bilden einer Barriereschicht (208), der metallischen leitenden Schicht (203) und der Opferschicht (204), die in Abfolge gestapelt werden, auf beiden Seiten der Rille (207'),
wobei ein Bilden (S105) der Isolationsstruktur (207) zwischen den benachbarten metallischen leitenden Schichten (203) Folgendes umfasst: Bilden (S505) der Isolationsstruktur (207) in der Rille (207').

11. Verfahren nach Anspruch 2, wobei die anfängliche Opferschicht (204a) auf der anfänglichen metallischen leitenden Schicht (203a) unter Verwendung eines Prozessgases gebildet wird, umfassend: Sauerstoff, ein Wasserstoff-Stickstoff-Gemisch, Stickstoff und Argon, wobei das Prozessgas mit einer Durchflussrate im Bereich von 100 Standard-ml/min bis 15.000 Standard-ml/min einströmt, wobei der Druck in einem Bereich, in dem das Sauerstoffplasma (40a) erzeugt wird, in einem Bereich von 10 mtorr bis 10.000 mtorr ist, wobei die Hochfrequenzleistung im Bereich von 10 W bis 10.000 W ist.

## Revendications

1. Procédé de formation d'une structure semi-conductrice, comprenant :
la fourniture (S101) d'un substrat (201), dans lequel une couche d'isolation (202), une couche conductrice métallique initiale (203a), une couche de sacrificielle initiale (204a) et une couche de masque (205a) empilées dans l'ordre sont formées sur le substrat (201), dans lequel la couche de sacrificielle initiale (204a) comprend une couche d'oxyde métallique ;
la formation (S102) d'une couche conductrice métallique (203) et d'une couche sacrificielle (204) sur la couche conductrice métallique (203) en gravant la couche sacrificielle initiale (204a) et la couche conductrice métallique initiale (203a) en utilisant un gaz source d'oxygène comme gaz de gravure sur la base d'une couche de masque à motifs (205), ainsi qu'en permettant à un premier sous-produit formé pendant la gravure de comprendre principalement un oxyde métallique ;
l'élimination (S103, S503) de la couche de masque à motifs (205) en effectuant un processus de décapage en utilisant le gaz source d'oxygène comme gaz de gravure, le gaz source d'oxygène permettant en outre à un second sous-produit formé dans le processus de décapage d'inclure principalement un oxyde métallique ;
l'élimination (S104, S504) de la couche sacrificielle (204), ainsi que de sous-produits (206), y compris le premier sous-produit formé pendant la gravure et le second sous-produit formé pendant le processus de décapage, et l'exposition de la couche conductrice métallique (203) en effectuant un processus de corrosion à l'aide d'une solution de corrosion alcaline ; et
la formation (S105) d'une structure d'isolation (207) entre les couches conductrices métalliques adjacentes (203).

2. Procédé selon la revendication 1, dans lequel la couche sacrificielle initiale (204a) est formée par :
l'exécution d'un processus de planarisation sur la couche conductrice métallique initiale (203a) ; et
la formation de la couche sacrificielle initiale (204a) sur la couche conductrice métallique initiale (203a) en oxydant la couche conductrice métallique initiale (203a) à l'aide d'un plasma d'oxygène (40a),
dans lequel la couche conductrice métallique initiale (203a) et la couche conductrice métallique (203) sont constituées d'un matériau comprenant du tungstène, dans lequel la couche sacrificielle initiale (204a) est constituée d'un matériau comprenant de l'oxyde de tungstène.

3. Procédé selon la revendication 1, dans lequel la couche de masque (205a) comprend une couche de carbone amorphe, dans lequel la formation de la couche conductrice métallique (203) et de la couche sacrificielle (204) sur la couche conductrice métallique (203) par gravure de la couche sacrificielle initiale (204a) et de la couche conductrice métallique initiale (203a) en utilisant le gaz source d'oxygène comme le gaz de gravure sur la base de la couche de masque à motifs (205) comprend :
la formation d'une couche de carbone amorphe à motifs sur la couche sacrificielle initiale (204a) ; et
la formation de la couche conductrice métallique (203) et de la couche sacrificielle (204) sur la couche conductrice métallique (203) en gravant la couche sacrificielle initiale (204a) et la couche conductrice métallique initiale (203a) par gravure au plasma d'oxygène in situ (40a) sur la base de la couche de carbone amorphe à motifs.

4. Procédé selon la revendication 3, dans lequel l'élimination de la couche de masque à motifs (205) par l'exécution du processus de décapage en utilisant le gaz source d'oxygène comme le gaz de gravure comprend :
l'élimination de la couche de carbone amorphe à motifs en effectuant le processus de décapage à l'aide d'un plasma d'oxygène (40a).

5. Procédé selon l'une quelconque des revendications 1 à 4, dans lequel les sous-produits (206) formés au cours du processus de gravure et du processus de décapage comprennent un oxyde de tungstène.

6. Procédé selon l'une quelconque des revendications 1 à 4, dans lequel l'élimination de la couche sacrificielle (204), ainsi que des sous-produits (206) formés au cours du processus de gravure et du processus de décapage et l'exposition de la couche conductrice métallique (203) en effectuant le processus de corrosion à l'aide de la solution de corrosion alcaline comprennent :
l'élimination d'un oxyde naturel sur la couche sacrificielle (204) et l'exposition de la couche sacrificielle (204), ainsi que des sous-produits (206) formés au cours du processus de gravure et du processus de décapage par prétraitement d'une surface de la couche sacrificielle (204) ;
l'élimination de la couche sacrificielle (204), ainsi que les sous-produits (206) formés au cours du processus de gravure et du processus de décapage à l'aide de la solution de corrosion alcaline, et l'exposition de la couche conductrice métallique (203) ;
l'élimination de la solution de corrosion alcaline restant sur la couche conductrice métallique (203) ; et
le séchage de la couche conductrice métallique (203).

7. Procédé selon l'une quelconque des revendications 1 à 4, dans lequel la solution de corrosion alcaline comprend un mélange d'ammoniaque et d'eau désionisée (ADM), dans lequel un rapport en volume entre l'ammoniaque et l'eau désionisée dans l'ADM se situe dans la plage de 5:1 à 1 000:1.

8. Procédé selon la revendication 6, dans lequel la couche conductrice métallique (203) est séchée à l'aide d'alcool isopropylique et d'azote.

9. Procédé selon l'une quelconque des revendications 1 à 4, dans lequel la formation de la structure d'isolation (207) entre les couches conductrices métalliques adjacentes (203) comprend :
la formation de la structure d'isolation (207) en formant séquentiellement une première couche diélectrique (207a) et une seconde couche diélectrique (207b) entre les couches conductrices métalliques adjacentes (203).

10. Procédé selon la revendication 1, dans lequel une couche barrière initiale (208a) située entre la couche d'isolation (202) et la couche conductrice métallique initiale (203a) est également formée (S501) sur le substrat (201),
dans lequel la formation (S102) de la couche conductrice métallique (203) et de la couche sacrificielle (204) sur la couche conductrice métallique (203) par gravure de la couche sacrificielle initiale (204a) et de la couche conductrice métallique initiale (203a) en utilisant le gaz source d'oxygène comme le gaz de gravure sur la base de la couche de masque à motifs (205) comprend :
la formation (S502) d'une rainure (207') en gravant la couche sacrificielle initiale (204a), la couche conductrice métallique initiale (203a) et la couche barrière initiale (208a) en utilisant le gaz source d'oxygène comme le gaz de gravure sur la base de la couche de masque à motifs (205), et la formation, des deux côtés de la rainure (207'), d'une couche barrière (208), de la couche conductrice métallique (203) et de la couche sacrificielle (204) qui s'empilent dans l'ordre,
dans lequel la formation (S105) de la structure d'isolation (207) entre les couches conductrices métalliques adjacentes (203) comprend : la formation (S505) de la structure d'isolation (207) dans la rainure (207').

11. Procédé selon la revendication 2, dans lequel la couche sacrificielle initiale (204a) est formée sur la couche conductrice métallique initiale (203a) à l'aide d'un gaz de traitement comprenant : de l'oxygène, un mélange d'hydrogène et d'azote, de l'azote et de l'argon, dans lequel le gaz de traitement s'écoule à un débit allant de 100 ml standard/min à 15 000 ml standard/min, dans lequel une pression d'une région où le plasma d'oxygène (40a) est produit va de 10 mtorr à 10 000 mtorr, dans lequel une puissance de radiofréquence va de 10 W à 10 000 W.
